(19) Europäisches Patentamt

European Patent Office

Office européen des brevets

(11) **EP 0 298 155 B1**

## (12) EUROPEAN PATENT SPECIFICATION

(45) Date of publication and mention
of the grant of the patent:
**02.06.1999 Bulletin 1999/22**

(51) Int Cl.[6]: **H01L 21/285**, C23C 16/08,
C23C 16/04

(21) Application number: **87117894.3**

(22) Date of filing: **03.12.1987**

(54) **Method of forming refractory metal film**

Verfahren zur Herstellung einer schmelzfesten Metallschicht

Procédé pour former une couche de métal réfractaire

(84) Designated Contracting States:
**DE NL**

(30) Priority: **10.07.1987 JP 171218/87**

(43) Date of publication of application:
**11.01.1989 Bulletin 1989/02**

(73) Proprietor: **KABUSHIKI KAISHA TOSHIBA**
**Kawasaki-shi (JP)**

(72) Inventors:
 • **Itoh, Hitoshi**
  **Mitaka-shi Tokyo (JP)**
 • **Moriya, Takahiko**
  **Yokohama-shi Kanagawa-ken (JP)**

(74) Representative:
**Hansen, Bernd, Dr. Dipl.-Chem. et al**
**Hoffmann Eitle,**
**Patent- und Rechtsanwälte,**
**Postfach 81 04 20**
**81904 München (DE)**

(56) References cited:
**EP-A- 0 090 319**     **EP-A- 0 134 571**
**EP-A- 0 143 652**     **DE-A- 3 134 702**

 • **JOURNAL OF THE ELECTROCHEMICAL**
  **SOCIETY vol. 133 , no. 9, September 1986, pages**
  **1905-1912, Manchester, NH, US; R.A. LEVY et al.:**
  **"Selective LPCVD Tungsten for Contact Barrier**
  **Applications".**
 • **PATENT ABSTRACTS OF JAPAN vol. 7, no. 136**
  **(E-181), 14 June 1983; & JP-A-58 051 510**
  **(FUJITSU K.K.) 26.03.1983**
 • **PROCEEDINGS OF THE SECOND**
  **INTERNATIONAL IEEE VLSI MULTILEVEL**
  **INTERCONNECTION CONFERENCE 25-26 June**
  **1985, pages 357-362, New York, US; W.A. METZ**
  **et al.: "LPCVD Tungsten metallization for**
  **multilevel interconnect processes".**

## Description

BACKGROUND OF THE INVENTION

Field of the Invention

The present invention relates to a method of manufacturing semiconductor devices, and particularly to a method of forming refractory metal films of high quality at a high speed.

Description of the Prior Art

High integration in a semiconductor device can be realized by micronizing its component elements. For instance, a 1M-bit DRAM or a 256K-bit SRAM is presently manufactured based on a design rule of 1 to 1.2μm. In the future, the design rule of semiconductors will be micronized further to the order of sub-micron.

Such a micronization causes many problems in processing and manufacturing the semiconductor devices. Taking wiring for instance, the width of wiring becomes smaller and the length thereof longer, due to the micronization of design rule. In addition, as the number of active elements in a semiconductor device increases, the number of locations which shall be connected electrically is increased to enlarge the aspect ratio (contact depth/contact width) of each contact hole of the semiconductor device. As a result, wiring using a material of normal Al/1%Si tends to frequently cause problems such as open defects (disconnection of wiring), discontinuity in the bottoms of connection holes, an increase in contact resistance, and electromigration, thereby deteriorating the quality and reliability of wiring.

To solve the problems, there is a demand for new wiring materials and new wiring structures. For instance, to prevent the contact resistance from increasing, a diffusion barrier layer made of refractory metal or a titanium nitride (TiN) film/titanium (Ti) structure is disposed between aluminum (Al) or Al/Si alloy and a silicon (Si) substrate to provide a wiring structure of the refractory metal film. The refractory metal films or their silicide films are thought to be potent as one of new wiring materials. Namely, films made of refractory metals such as tungsten (W), titanium (Ti), molybdenum (Mo), and their silicides are used as diffusion barrier layers of the contacts of semiconductor devices, or as gate electrodes of field-effect transistors (FETs). To form a film from a refractory metal or from its silicide, a high-speed sputtering method is usually adopted. Also, it is tried to use a chemical vapor deposition (CVD) method for the same purpose. When the CVD method is used to form a thin film under a reduced pressure of several torrs (a reduced-pressure CVD method), a so-called roundabout phenomenon of reactive gas is caused to form a refractory metal film on the bottom of a groove having a large aspect ratio, and a film thickness of the refractory metal formed on the bottom is the same as that of a film formed on a flat portion of the surface of a substrate. Therefore, for the metalization of a VLSI designed according to a fine design rule and having wiring of small pitch and space as well as having narrow contact holes, the reduced-pressure CVD method is a remarkably effective method in forming thin films.

Particularly, a tungsten (W) selective CVD method which forms a tungsten (W) film only a particular region of a substrate can simplify the processes of semiconductor device manufacturing and produce reliable tungsten films. Therefore, the tungsten selective CVD method is observed that it has many practical advantages compared to other thin film forming methods.

The tungsten selective CVD method uses a mixed gas made of a halide of tungsten (usually, tungsten hexafluoride ($WF_6$)) and hydrogen ($H_2$ as a source gas to selectively form, according to the CVD method, a tungsten film only on refractory metal such as silicon, aluminum or its alloy, and tungsten but not on an insulating film such as a silicon oxide film.

Usually, such a tungsten selective CVD method may realize a high-speed deposition to a certain extent, but not provide films of good quality so that, in some cases, the method may not be used in a wiring process.

Further, the tungsten selective CVD method has a limit in temperature at which a stable deposition speed is obtainable. For instance, it will be about 300°C to 340°C when the method is performed under a heating lamp in a cold wall type reactive furnace. Generally, it is difficult to strictly maintain the temperature at a constant value because of a wide error range. If the above-mentioned temperature range is not kept, it will be difficult to control the deposition speed.

According to another tungsten selective CVD method which is adopted widely and uses a $WF_6$-$H_2$ system, the deposition of tungsten is always made by the reduction reaction of $WF_6$ with substrate materials such as silicon. The deposition of tungsten causes a so-called "biting" which is a consumption of substrate materials. If the "biting" is caused excessively when tungsten is deposited on a portion of silicon substrate where a diffusion layer is formed, the diffusion layer tends to be destroyed by the "biting". As mentioned in the above, the selective tungsten CVD method using the $WF_6$-$H_2$ system hardly suppresses the consumption of substrate materials with good reproducibility. On the other hand, with the normal CVD method, it is difficult to maintain good selectivity of locations at which thick tungsten films are formed, and a practical high deposition speed.

Journal of the Electrochemical Society, vol. 133, no. 9, September 1986, pp. 1905-1912 discloses a selective deposition of W on wafers of silicon at 290°C and at a total pressure of 1.42 torr with $WF_6$ contributing a 10 mtorr partial pressure, $SiF_4$ contributing 2 mtorr, and $H_2$ accounting for the balance.

EP-A-0 143 652 includes a process according to which refractory metal silicides are deposited by a selective chemical vapor deposition using a refractory metal halide gas, a gas including silicon and a hydrogen gas.

EP-A-0 090 319 also refers to a method for the selective deposition of refractory metal silicides by using a refractory metal halide, hydrogen and a halogenated silane gas.

Patent Abstracts of Japan, vol. 7, no. 136, (E-181) & JP-A-58051510 refers to the formation of a silicide layer having excellent densifying properties by mixing the gas of the fluoride of a refractory metal, monosilane and hydrogen and reacting the mixed gas with a semiconductor compound.

1985 Proceedings, Second International IEEE VLSI Multilevel Interconnection Conference, "LPCVD Tungsten Metallization for Multilevel Interconnect Processes", V.A. Metz and E.A. Beam, describes a deposition procedure which is carried out by a reaction of $WF_6$ with $SiH_4$ and $H_2$ at a temperature of 500°C to 600°C and pressures of 200 to 500 mTorr.

## SUMMARY OF THE INVENTION

An object of the present invention is to provide a chemical vapor deposition method of forming refractory metal films with good quality at selected locations at a high deposition speed.

Another object of the present invention is to provide a selective vapor deposition method of forming refractory metal films having good quality at selected locations at a high deposition speed.

In order to accomplish the objects mentioned in the above, the present invention provides a method of selectively forming a refractory metal film on a predetermined region on or over a semiconductor substrate in a reactive vessel by a reduction reaction. The method comprises the steps of forming the predetermined region on or over the substrate; and introducing into the reactive vessel, at least one gas selected in a gas group of the halides of refractory metals selected from tungsten, titanium, and tantalum in a quantity Q1, at least one gas selected in a gas group of $SiH_4$, $Si_2H_6$, $SiH_2Cl_2$, $SiH_2F_2$, $Si_2H_4Cl_2$, $Si_2H_2Cl_4$, $Si_2H_4F_2$, $Si_2H_2F_4$ in a quantity Q2, and a hydrogen gas, wherein the ratio $R = Q2/Q1$ is less than or equal to 1.5 when the substrate temperature T is between 350 and 600°C, and the ratio $R = Q2/Q1$ is less than or equal to 3 when the substrate temperature T is between 250°C and 350°C, and the total pressure of the gases is $1.3 \leq p \leq 665$ Pa ($0.01 \leq p \leq 5$ Torr).

The above-mentioned step for forming the predetermined region comprises a step of forming on the semiconductor substrate a region of reverse conduction type with respect to the substrate, and a step of forming on the substrate an insulating film having an opening reaching to the reverse conduction type region, in which the predetermined region comprises the reverse conduction type region at the opening.

## BRIEF DESCRIPTION OF THE DRAWINGS

These and other objects, features and advantages of the present invention will become apparent from the following description of preferred embodiments taken in conjunction with the accompanying drawings in which:

Figs. 1A and 1B are sectional views showing processes for selectively forming a refractory metal film on a semiconductor substrate according to a first embodiment of the present invention;

Figs. 2A and 2B are sectional views showing processes for selectively forming a refractory metal film on a semiconductor substrate according to a second embodiment of the present invention;

Figs. 3A to 3D are sectional views showing processes for selectively forming a refractory metal film on a semiconductor substrate according to a third embodiment of the present invention;

Figs. 4A to 4C are sectional views showing processes for selectively forming a refractory metal film on a semiconductor substrate according to a fourth embodiment of the present invention; and

Fig. 5 is a graph showing the relation between changes in free energy and changes in enthalpy in various reactions.

## DETAILED DESCRIPTION OF THE EMBODIMENTS

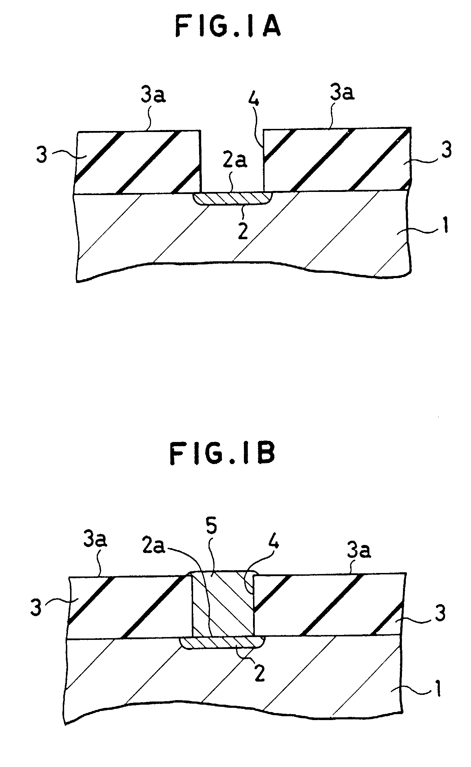

Figures 1A and 1B are sectional views showing processes according to the first embodiment of the present invention. A p-type silicon substrate 1 is subjected to an element separation and an arsenic (As) ion implantation, and activated to form an $n^+$ diffusion layer 2 as shown in Fig. 1A. Then, a silicon oxide film 3 is deposited on the substrate 1, and a contact hole 4 is formed by using a normal optical exposure method. Through the contact hole 4, an electrode is connected to the diffusion layer 2. On the surface of the substrate 1, there are an exposed surface portion 2a of the silicon $n^+$ diffusion layer 2 and an exposed surface portion 3a of the silicon oxide film 3.

The substrate 1 is properly processed chemically or physically to clean the silicon surface 2a and the silicon oxide film surface 3a, and then placed in a vacuum CVD furnace of a normal diffusion type. An argon gas of 0 to 2000cc/min and a hydrogen gas of 200 to 3000cc/min are introduced into the furnace, and the substrate 1 is heated to a predetermined temperature between 200°C and 600°C. The flow rate of the hydrogen ($H_2$) gas is properly set according to deposition conditions and stabilized, and a dichlorosilane ($SiH_2Cl_2$) gas of 1 to 200cc/min is poured onto the substrate 1. At this time and within the above-mentioned temperature range, the dichlorosilane does not dissolve to deposit on the substrate 1.

While the hydrogen and $SiH_2Cl_2$ gases are be-

ing poured onto the substrate 1, a $WF_6$ gas of 0.1 to 100cc/min is added. Then, a tungsten 5 selectively deposits on the silicon $n^+$ diffusion layer surface 2a on the bottom of the contact hole 4 at a deposition speed of 100 to 15000Å/min as shown in Fig. 1B. At this time, the tungsten is not formed on the surface 3a of the silicon oxide film 3, i.e., the selectivity is perfect.

Since the selective deposition of tungsten is realized by the surface reaction of $WF_6$ and $SiH_2Cl_2$ the "biting" of tungsten on the substrate caused by the prior art method using $WF_6$ and $H_2$ is remarkably suppressed so that a junction destruction is not caused.

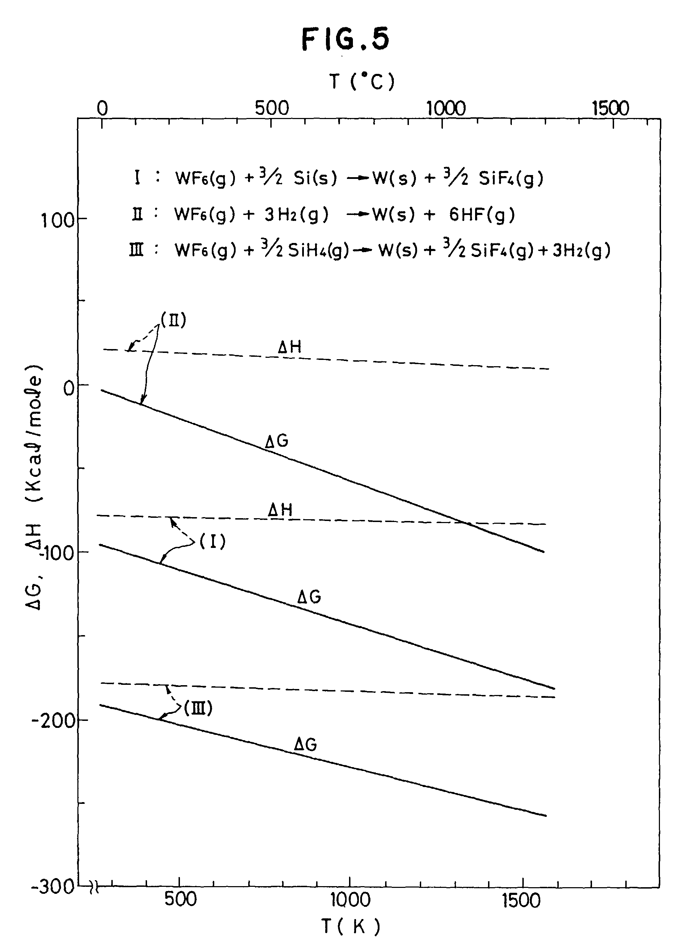

This effect will be described with reference to a graph shown in Fig. 5 where an axis of abscissa represents changes in temperature and an axis of ordinate representing changes in energy. In the graph, "I" represents a free energy change G and an enthalpy change H in a reaction of tungsten and silicon; "II" G and H in a reaction of tungsten and hydrogen; and "III" G and H in a reaction of tungsten and silane. The smaller the free energy change G, the easier the reaction to occur. A value of the free energy change G in the reaction of tungsten and hydrogen "II" is larger than that in the reaction of tungsten and silicon "I". This means that the reaction of tungsten and silicon may occur easier than that of tungsten and hydrogen, and that the "biting" phenomenon is caused when the mixed gas of $WF_6$ and $H_2$ is used.

The free energy change G in the reaction of tungsten and silane "III" is smaller than that in the reaction of tungsten and silicon. This means that the reaction of tungsten and silane may occur easier than that of tungsten and silicon, and that the "biting" phenomenon is remarkably suppressed by using the mixed gas of $WF_6$ and $SiH_2$ according to the present invention.

Although dichlorosilane ($SiH_2Cl_2$) has been used in this embodiment, a gas of silane, disilane, or the halides of the silane and disilane may be used instead of the dichlorosilane to provide the same effect.

In comparing (i) introducing an $H_2$ gas as in the case of this embodiment with (ii) introducing an argon (Ar) gas in place of the $H_2$ gas, the case (i) with the $H_2$ gas has a slower deposition speed than the case (ii) with the Ar gas, but the case (i) has a wider temperature range in which a predetermined deposition speed is obtainable as well as realizing a practical good film quality.

As a result of the analysis of selectivity, it has been found that the selectivity depends on a flow rate $Q_1$ of $WF_6$ and a flow rate $Q_2$ of $SiH_2Cl_2$, and that, as the flow rate $Q_1$ is increased, the selectivity increases while a deposition speed of the tungsten film decreases. If the flow rate $Q_2$ is increased, the deposition speed increases while the selectivity is deteriorated to form the tungsten film allover the substrate surface.

The ranges of $Q_1$ and $Q_2$ in which the good selectivity is obtainable strongly depend on the temperature, pressure and flow rate ratio.

A flow rate ratio with which a good selectivity can be provided is as follows:

$$Q_2/Q_1 \leqq 3.$$

However, when a deposition temperature T rises, the selectivity tends to be deteriorated particular in a central region of the substrate when the ratio is $Q_2/Q_1 > 2$. The selectivity can be maintained sufficiently with a ratio of $Q_2/Q_1 \leqq 3$ for a deposition temperature of $250°C \leqq T \leqq 350°C$, and with a ratio of $Q_2/Q_1 \leqq 1.5$ for a deposition temperature of $350°C \leqq T \leqq 600°C$. Deposition pressure is also an important factor influencing the selectivity, and the good selectivity can be obtained with 0.01 to 5 torrs for the above-mentioned conditions. The lower the deposition pressure, the better the selectivity.

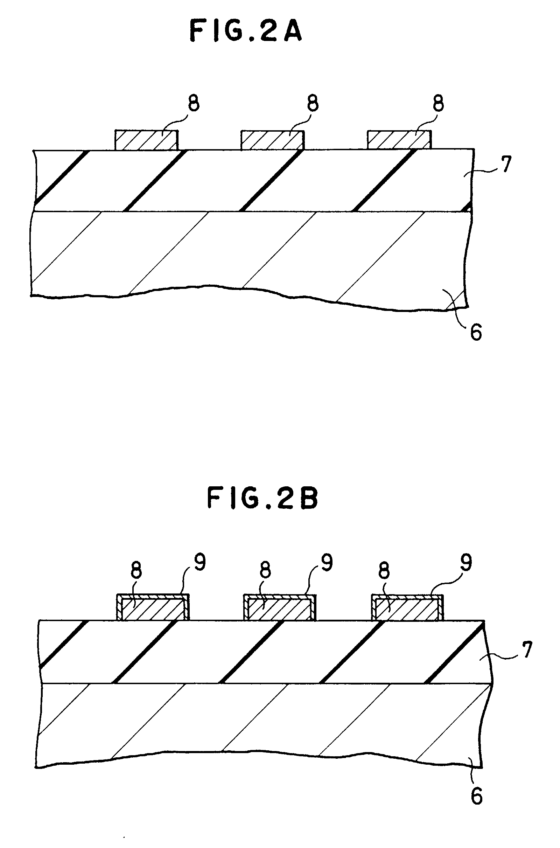

Figures 2A and 2B are sectional views showing processes for selectively forming a refractory metal film according to the second embodiment of the present invention. A silicon oxide film 7 with a thickness of 8000Å is formed on a p-type silicon substrate 6. Then, a chemical spattering is used to form a titanium nitride (TiN) film 8 with a thickness of 1000A is formed on the film 7, and the titanium nitride film 8 is subjected to a patterning by a normal optical exposure method as shown in Fig. 2A.

Similar to the first embodiment, the substrate is placed in a vacuum CVD furnace of a normal diffusion type. An argon gas of 0 to 2000cc/min and a hydrogen gas of 200 to 3000cc/min are poured onto the substrate which is heated to a predetermined temperature between 200°C to 600°C. Then, the flow rate of the hydrogen gas is properly adjusted according to the deposition conditions and stabilized. A dichlorosilane ($SiH_2Cl_2$) gas of 1 to 1000cc/min is poured onto the substrate. At this time, within the above-mentioned temperature range, $SiH_2Cl_2$ does not dissolve to deposit on the substrate.

While the hydrogen gas and $SiH_2Cl_2$ gas are being poured onto the substrate, a $WF_6$ gas of 0.1 to 100cc/min is added. As a result, a tungsten film 9 deposits with a deposition speed of 100 to 2000Å/min only on the titanium nitride film 8 as shown in Fig. 2B. On the contrary, if a normal mixed gas of $WF_6$ and $H_2$ is used with the above-mentioned deposition conditions, the tungsten film does not deposit on the TiN film 8, or the tungsten film deposits allover the substrate surface but not over the TiN film 8.

The reason of this is considered as follows.

A reaction of $WF_6$ and $H_2$ in the prior art method occurs in a process where the adsorption and dissociation of hydrogen with respect to the substrate tends to govern the reaction. The adsorption and dissociation of hydrogen is easy to occur on the surface of a metal such as tungsten (W) while it is hard to occur on the surface of a material which has strong covalent bonding. Therefore, the deposition reaction of tungsten (W) is hard to occur on an oxide film or on a nitride film of metal or silicon. On the other hand, in the reaction of $WF_6$ and

$SiH_2Cl_2$ according to the present invention, the adsorption and dissociation of $SiH_2Cl_2$ is larger than that of hydrogen. Further, the dissociation generates Si, H and Cl, and Si greatly contributes to the reduction of $WF_6$ while H and Cl suppress the reaction speed to make the control of the reaction speed easier.

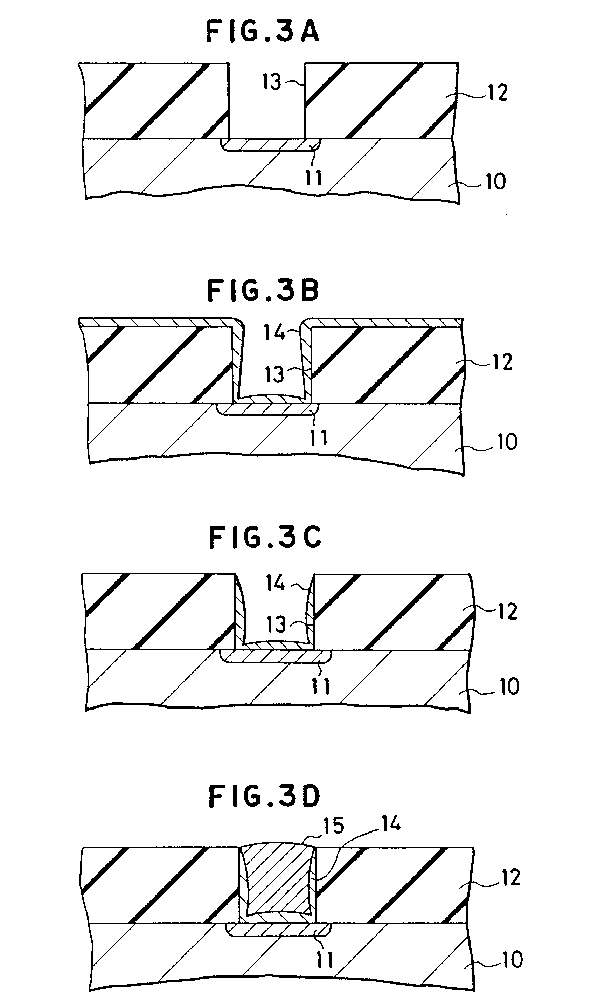

Figures 3A to 3D are sectional views showing processes for forming a refractory metal film according to the third embodiment of the present invention. A p-type silicon substrate 10 is subjected to an element separation and an arsenic (As) ion implantation, and activated to form an $n^+$ diffusion layer 11 thereon. After that, a silicon dioxide film 12 is formed on the substrate, and a patterning is carried out by using a normal optical exposure method. The exposed silicon oxide film is etched by a reactive ion spattering method, etc., to form a contact hole 13 as shown in Fig. 3A. The substrate is then subjected to a proper dry processing and a wet processing. By using the reactive spattering method, etc., a titanium nitride (TiN) film 14 is formed on the contact hole 13 and on the silicon dioxide film 12 as shown in Fig. 3B. Again, the optical exposure method and the reactive spattering method are used to leave the TiN film 14 on the bottom and side walls of the contact hole 13 as shown in Fig. 3C. The substrate is then placed in a vacuum CVD furnace to selectively deposit a tungsten 15 on the TiN as in the second embodiment to fill the contact hole 13 with the tungsten 15 to form a flat substrate surface as shown in Fig. 3D.

Since the selective deposition of tungsten is caused by the surface reaction of $WF_6$ and $SiH_2Cl_2$, the so-called "biting" of the substrate by the tungsten caused when a conventional mixed gas of $WF_6$ and $H_2$ is used is remarkably suppressed so that a junction destruction may not be caused.

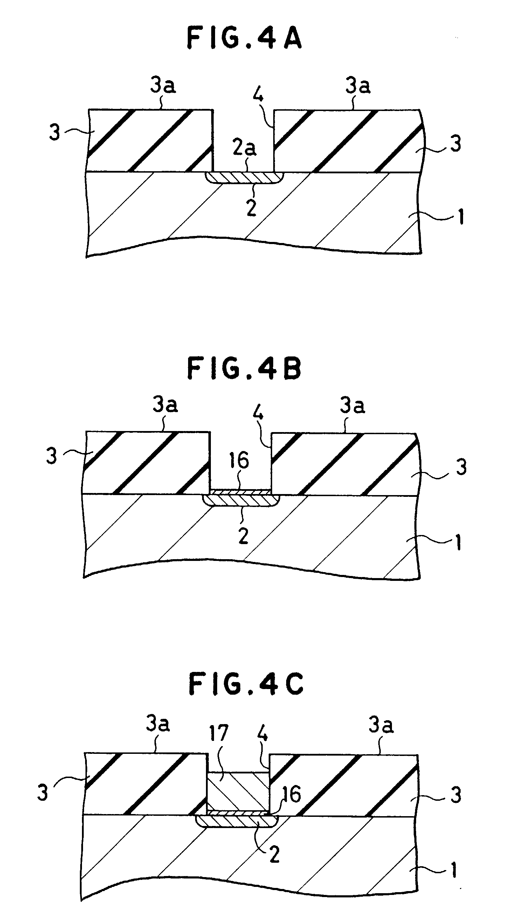

Figures 4A to 4D are views showing processes for selectively forming a refractory metal film according to the fourth embodiment of the present invention. Similar to the first embodiment, a p-type silicon substrate 1 is subjected to an element separation and an arsenic (As) ion implantation, and activated to form an $n^+$ diffusion layer 2 thereon as shown in Fig. 4A. A silicon oxide film 3 is deposited on the substrate, and a contact hole 4 is formed by using a normal optical exposure method. Through the contact hole 4, an electrode is connected to the diffusion layer 2. On the surface of the substrate, there are an exposed surface portion 2a of the $n^+$ silicon diffusion layer 2 and an exposed surface portion 3a of the silicon oxide film 3.

The substrate is chemically or physically processed to clean the silicon surface 2a and the silicon oxide film surface 3a, and placed in a vacuum CVD furnace of a normal diffusion type. A hydrogen gas is poured into the furnace at a flow rate of 200 to 3000cc/min, and the substrate is heated to a predetermined temperature between 250°C and 400°C. The flow rate of the hydrogen ($H_2$) gas is properly set according to deposit conditions and stabilized. While the hydrogen gas is being poured onto the substrate, a $WF_6$ gas of 0.5 to 50 cc/min is added at the temperature between 250°C and 400°C. Then, a tungsten thin film 16 is selectively formed on the silicon surface 2a on the bottom of the contact hole 4 as shown in Fig. 4B.

After that, a hydrogen ($H_2$) gas is poured onto the substrate according to the deposition conditions and stabilized. A dichlorosilane ($SiH_2Cl_2$) gas is then poured onto the substrate at a flow rate of 1 to 200cc/min.

While the hydrogen and $SiH_2Cl_2$ gases are being poured onto the substrate at the temperature between 250°C and 400°C, a $WF_6$ gas is added at a flow rate of 1 to 100 cc/min. Due to this, as shown in Fig. 4C, a tungsten 17 selectively deposits with a deposition speed of 100 to 15000Å/min on the tungsten thin film 16 in the contact hole 4. At this time, the tungsten does not deposit on the surface 3a of the silicon oxide film 3, i.e., the selectivity is perfect.

The substrate is then heated to a predetermined temperature of 500°C, and a gas comprising $N_2$ and $H_2$ is added at a flow rate of 2cc/min to perform a heat treatment.

In this fourth embodiment, the nixed gas of $WF_6$ and $H_2$ is used to form the tungsten thin film 16, and the mixed gas of $WF_6$ and $SiH_2Cl_2$ to form the thick tungsten deposition layer 17 on the tungsten thin film 16. Due to the above, the "biting" phenomenon is suppressed and the adhesive force of tungsten with respect to the $n^+$ diffusion layer 2 can be increased. Namely, when the mixed gas of $WF_6$ and $H_2$ is used, the amount of tungsten is sufficiently small to suppress the "biting" phenomenon. In addition, strong adhesive force is generated between the tungsten thin film 16 and the surface 2a of the $n^+$ diffusion layer 2. When the mixed gas of $WF_6$ and $SiH_2Cl_2$ is used, strong adhesive force is generated between the tungsten thin film 16 and the tungsten deposition layer 17.

Although tungsten hexafluoride ($WF_6$) has been used as the halide of a refractory metal in the embodiments, it is possible to use as the refractory metal not only tungsten but also titanium, tantalum and molybdenum. In addition, the chloride of the refractory metal is also effective to use.

The halide of monosilane or disilane to be added will be not only $SiH_2Cl_2$ but also $SiH_2F_2$ $Si_2H_4Cl_2$, $Si_2H_2Cl_4$, $Si_2H_4F_2$, and $Si_2H_2F_4$.

The method according to the present invention can be used to form a refractory metal film of about 1000Å to be used as a barrier metal for the source, drain and gate regions of a MOS transistor. In this case, the refractory metal film can lower the resistance of a contact portion.

In summary, the method for forming a refractory metal film according to the present invention utilizes a reduction reaction of the halide of refractory metal with respect to the halide of monosilane or disilane to form a refractory metal film while suppressing the reaction by adding a hydrogen gas. As a result, the refractory metal film can be formed with good quality at a high speed, or can selectively be deposited on the nitride of a metal.

## Claims

1. A method of selectively forming a refractory metal film on a predetermined region on or over a semiconductor substrate in a reactive vessel by a reduction reaction, comprising the steps of:

   (a) forming the predetermined region on or over the substrate; and
   (b) introducing into the reactive vessel, at least one gas selected from a group of gases of halides of refractory metals selected from tungsten, titanium and tantalum in a quantity Q1, at least one gas selected among a group of gases of $SiH_4$, $Si_2H_6$, $SiH_2Cl_2$, $SiH_2F_2$, $Si_2H_4Cl_2$, $Si_2H_2Cl_4$, $Si_2H_4F_2$ and $Si_2H_2F_4$ in a quantity Q2 and a hydrogen gas, wherein the ratio $R = Q2/Q1$ is less than or equal to 1.5 when the substrate temperature T is between 350 and 600°C, and the ratio $R = Q2/Q1$ is less than or equal to 3 when the substrate temperature T is between 250°C and 350°C, and the total pressure of the gases is $1.3 \leq p \leq 665$ Pa ($0.01 \leq p \leq 5$ Torr).

2. The method as claimed in claim 1, wherein said step for forming the predetermined region comprises the steps of:

   forming on a semiconductor substrate a region of conduction type which is reverse to a type of the substrate; and
   forming on the substrate an insulating film having an opening reaching to the reverse conduction type region, the predetermined region comprising the reverse conduction type region located at the opening.

3. The method as claimed in claim 1, wherein said step for forming the predetermined region comprises the steps of:

   forming an insulating film on the substrate; and
   forming a metal wiring on the insulating film, the predetermined region comprising the surface of the metal wiring.

4. A method for selectively forming a refractory metal film on a predetermined region on or over a semiconductor substrate in a reactive vessel by a reduction reaction, comprising the steps of:

   a) forming the predetermined region on or over the substrate;
   b) introducing into the reactive vessel at least one gas selected among a group of gases of halides of refractory metals selected from tungsten, titanium and tantalum at a first predetermined quantity, and a hydrogen gas to selectively deposit the refractory metal on the predetermined region by the reduction reaction; and
   c) introducing into the reactive vessel at least one gas selected among the group of gases of halides of the above refractory metals at a second predetermined quantity Q1 which is greater than said first predetermined quantity, at least one gas selected among a group of gases of $SiH_4$, $Si_2H_6$, $SiH_2Cl_2$, $SiH_2F_2$, $Si_2H_4Cl_2$, $Si_2H_2Cl_4$, $Si_2H_4F_2$ and $Si_2H_2F_4$ in a quantity Q2, and a hydrogen gas, wherein the ratio $R = Q2/Q1$ is less than or equal to 1.5, when the substrate temperature T is between 350°C and 400°C and the ratio $R = Q2/Q1$ is less than or equal to 3 when the substrate temperature T is between 250°C and 350°C, and the total pressure of the gases is $1.3 \leq p \leq 665$ Pa ($0.01 \leq p \leq 5$ Torr), in order to selectively deposit the refractory metal further on the deposited refractory metal by a reduction reaction.

5. The method as claimed in claim 4, wherein said step for forming said predetermined region comprises the steps of:

   forming on the semiconductor substrate a region of conduction type which is reverse to a type of the substrate; and
   forming on the substrate an insulating film having an opening reaching to the reverse conduction type region, the predetermined region comprising the reverse conduction type region located at the opening.

6. The method as claimed in claim 4, wherein said step for forming the predetermined region comprises the steps of:

   forming an insulating film on the substrate; and
   forming a metal wiring on the insulating film, the predetermined region comprising the surface of the metal wiring.

7. The method as claimed in claim 4, further comprising the step of:

   d) heating the substrate to a predetermined temperature to carry out a heat treatment of the substrate.

8. The method as claimed in claim 7, wherein the predetermined temperature for said heat treatment is 500°C.

9. The method as claimed in claim 4, wherein the first predetermined quantity of the at least one gas selected among the group of gases of the halides of the refractory metal is 0.5 to 50 cc/min, and the second predetermined quantity Q1 thereof is 1 to 100 cc/min.

**Patentansprüche**

1. Verfahren zum selektiven Bilden einer schmelzfesten Metallschicht in einem vorherbestimmten Bereich auf oder über einem Halbleitersubstrat in einem Reaktionsgefäss durch eine Reduktionsreaktion, umfassend die Schritte:

    (a) Bilden des vorherbestimmten Bereichs auf oder über dem Substrat; und

    (b) Einführen mindestens eines Gases, ausgewählt aus der Gruppe von Gasen von Halogeniden schmelzfester Metalle, ausgewählt aus Wolfram, Titan und Tantal, in einer Menge Q1, mindestens eines Gases, ausgewählt aus einer Gruppe von Gasen von $SiH_4$, $Si_2H_6$, $SiH_2Cl_2$, $SiH_2F_2$, $Si_2H_4Cl_2$, $Si_2H_2Cl_4$, $Si_2H_4F_2$ und $Si_2H_2F_4$, in einer Menge Q2 und Wasserstoffgas in das Reaktionsgefäss, wobei das Verhältnis R = Q2/Q1 weniger als oder gleich 1,5 ist, wenn die Substrattemperatur T zwischen 350 und 600°C liegt, und das Verhältnis R = Q2/Q1 weniger als oder gleich 3 ist, wenn die Substrattemperatur zwischen 250 und 350°C liegt, und der Gesamtdruck der Gase $1,3 \leq p \leq 665$ Pa ($0,01 \leq p \leq 5$ Torr) beträgt.

2. Verfahren gemäss Anspruch 1, wobei der Schritt zum Bilden des vorherbestimmten Bereichs die Schritte umfasst:

    Bilden eines Bereichs eines Leitungstyps auf einem Halbleitersubstrat, der dem Typ des Substrats entgegengesetzt ist; und

    Bilden einer isolierenden Schicht mit einer Öffnung, die zu dem Bereich der entgegengesetzten Leitung reicht, wobei sich der vorherbestimmte Bereich, umfassend den Bereich der entgegengesetzten Leitung, an der Öffnung befindet.

3. Verfahren gemäss Anspruch 1, wobei der Schritt zum Bilden des vorherbestimmten Bereichs die Schritte umfasst:

    Bilden eines isolierenden Filmes auf dem Substrat; und

Bilden einer Metalldrahtleitung auf dem isolierenden Film, wobei der vorherbestimmte Bereich die Oberfläche der Metalldrahtleitung umfasst.

4. Verfahren zum selektiven Bilden einer schmelzfesten Metallschicht in einem vorherbestimmten Bereich auf oder über einem Halbleitersubstrat in einem Reaktionsgefäss durch eine Reduktionsreaktion, umfassend die Schritte:

    (a) Bilden des vorherbestimmten Bereichs auf oder über dem Substrat; und

    (b) Einführen in das Reaktiongefäss mindestens eines Gases, ausgewählt aus der Gruppe von Gasen von Halogeniden schmelzfester Metalle, ausgewählt aus Wolfram, Titan und Tantal, in einer ersten vorherbestimmten Menge, und Wasserstoffgas, um das schmelzfeste Metall in dem vorherbestimmten Bereich durch die Reduktionsreaktion selektiv abzuscheiden; und

    (c) Einführen in das Reaktionsgefäss von mindestens einem Gas, ausgewählt aus einer Gruppe von Gasen von Halogeniden der obigen schmelzfesten Metalle in einer zweiten vorherbestimmten Menge Q1, die grösser ist als die erste vorherbestimmte Menge, mindestens einem Gas, ausgewählt aus einer Gruppe von Gasen von $SiH_4$, $Si_2H_6$, $SiH_2Cl_2$, $SiH_2F_2$, $Si_2H_4Cl_2$, $Si_2H_2Cl_4$, $Si_2H_4F_2$ und $Si_2H_2F_4$ in einer Menge Q2 und Wasserstoffgas, wobei das Verhältnis R = Q2/Q1 weniger als oder gleich 1,5 ist, wenn die Substrattemperatur T zwischen 350 und 600°C liegt, und das Verhältnis R = Q2/Q1 weniger als oder gleich 3 ist, wenn die Substrattemperatur zwischen 250 und 350°C liegt, und der Gesamtdruck der Gase $1,3 \leq p \leq 665$ Pa ($0,01 \leq p \leq 5$ Torr) beträgt, um das schmelzfeste Metall weiter auf dem abgeschiedenen schmelzfesten Metall durch eine Reduktionsreaktion selektiv abzuscheiden.

5. Verfahren gemäss Anspruch 4, wobei der Schritt zum Bilden des vorherbestimmten Bereichs die Schritte umfasst:

    Bilden eines Bereichs eines Leitungstyps auf einem Halbleitersubstrat, der dem Typ des Substrats entgegengesetzt ist; und

    Bilden einer isolierenden Schicht mit einer Öffnung, die zu dem Bereich der entgegengesetzten Leitung reicht, wobei sich der vorherbestimmte Bereich, umfassend den Bereich der entgegengesetzten Leitung, an der Öffnung befindet.

6. Verfahren gemäss Anspruch 4, wobei der Schritt zum Bilden des vorherbestimmten Bereichs die Schritte umfasst:

    Bilden eines isolierenden Filmes auf dem Substrat; und

    Bilden einer Metalldrahtleitung auf dem isolierenden Film, wobei der vorherbestimmte Bereich die Oberfläche der Metalldrahtleitung umfasst.

7. Verfahren gemäss Anspruch 4, weiterhin umfassend den Schritt:

    (d) Erhitzen des Substrats auf eine vorherbestimmte Temperatur, um eine Wärmebehandlung des Substrats durchzuführen.

8. Verfahren gemäss Anspruch 7, wobei die vorherbestimmte Temperatur der Wärmebehandlung 500°C beträgt.

9. Verfahren gemäss Anspruch 4, wobei die erste vorherbestimmte Menge des mindestens einen Gases, ausgewählt aus der Gruppe von Gasen der Halogenide der schmelzfesten Metalle, 0,5 bis 50 cm$^3$/min. beträgt, und die zweite vorherbestimmte Menge Q1 hiervon 1 bis 100 cm$^3$/min. beträgt.

## Revendications

1. Procédé pour former sélectivement un film d'un métal réfractaire dans une région prédéterminée sur ou au-dessus d'un substrat semi-conducteur, dans un réacteur, par une réaction de réduction, comprenant les étapes consistant à :

    (a) former la région prédéterminée sur ou au-dessus du substrat; et
    (b) introduire dans le réacteur au moins un gaz choisi dans le groupe des gaz constitué par les halogénures de métaux réfractaires choisis parmi le tungstène, le titane et le tantale, en une quantité Q1, au moins un gaz choisi dans un groupe de gaz constitué par $SiH_4$, $Si_2H_6$, $SiH_2Cl_2$, $SiH_2F_2$, $Si_2H_4Cl_2$, $Si_2H_2Cl_4$, $Si_2H_4F_2$ et $Si_2H_2F_4$ en une quantité Q2 et du gaz hydrogène, le rapport R = Q2/Q1 étant inférieur ou égal à 1,5 quand la température T du substrat est entre 350 et 600 °C, le rapport R = Q2/Q1 étant inférieur ou égal à 3 quand la température du substrat T est entre 250 °C et 350 °C et la pression totale des gaz étant de $1,3 \leq p \leq 665$ Pa ($0,01 \leq p \leq 5$ Torrs).

2. Procédé selon la revendication 1, dans lequel ladite étape consistant à former la région prédéterminée comprend les étapes consistant à :

    former sur un substrat semi-conducteur une région d'un type de conduction opposée au type de conduction du substrat; et
    former sur le substrat un film isolant ayant une ouverture atteignant la région au type de conduction opposée, la région prédéterminée comprenant la région du type de conduction opposée située à l'ouverture.

3. Procédé selon la revendication 1, dans lequel ladite étape de formation de la région prédéterminée comprend les étapes consistant à :

    former un film isolant sur le substrat ; et
    former un conducteur métallique sur le film isolant, la région prédéterminée comprenant la surface du conducteur métallique.

4. Procédé pour former sélectivement un film d'un métal réfractaire dans une région prédéterminée sur ou au-dessus d'un substrat semi-conducteur, dans un réacteur, par une réaction de réduction, comprenant les étapes consistant à :

    (a) former la région prédéterminée sur ou au-dessus du substrat; et
    (b) introduire dans le réacteur au moins un gaz choisi dans le groupe des gaz constitué par les halogénures de métaux réfractaires choisis parmi le tungstène, le titane et le tantale, en une première quantité prédéterminée et du gaz hydrogène, pour déposer sélectivement le métal réfractaire sur la région prédéterminée, par la réaction de réduction; et
    (c) introduire dans le réacteur au moins un gaz choisi dans le groupe de gaz constitué par les halogénures des métaux réfractaires ci-dessus en une seconde quantité prédéterminée Q1 qui est supérieure à ladite première quantité prédéterminée, au moins un gaz choisi dans un groupe de gaz comprenant $SiH_4$, $Si_2H_6$, $SiH_2Cl_2$, $SiH_2F_2$, $Si_2H_4Cl_2$, $Si_2H_2Cl_4$, $Si_2H_4F_2$ et $Si_2H_2F_4$ en une quantité Q2 et du gaz hydrogène, le rapport R = Q2/Q1 étant inférieur ou égal à 1,5 quand la température T du substrat est entre 350 et 400 °C, le rapport R = Q2/Q1 étant inférieur ou égal à 3 quand la température du substrat T est entre 250 °C et 350 °C et la pression totale des gaz étant de $1,3 \leq p \leq 665$ Pa ($0,01 \leq p \leq 5$ Torrs), pour déposer sélectivement du métal réfractaire additionnel sur le métal réfractaire déposé par une réaction de réduction.

**5.** Procédé selon la revendication 4, dans lequel ladite étape pour former ladite région prédéterminée comprend les étapes consistant à :

former sur le substrat semi-conducteur une région d'un type de conduction qui est opposée au type de conduction du substrat; et former sur le substrat un film isolant ayant une ouverture atteignant la région à type de conduction opposée, la région prédéterminée comprenant la région à type de conduction opposée située à l'ouverture.

**6.** Procédé selon la revendication 4, dans lequel ladite étape de formation de la région prédéterminée comprend les étapes consistant à :

former un film isolant sur le substrat; et former un conducteur métallique sur le film isolant, la région prédéterminée comprenant la surface du conducteur métallique.

**7.** Procédé selon la revendication 4, comprenant en outre l'étape consistant à :

d) chauffer le substrat à une température prédéterminée pour effectuer un traitement thermique du substrat.

**8.** Procédé selon la revendication 7, dans lequel la température prédéterminée pour ledit traitement thermique est de 500 °C.

**9.** Procédé selon la revendication 4, dans lequel la première quantité prédéterminée du ou des gaz choisi ou choisis dans le groupe des gaz constitué par les halogénures des métaux réfractaires est de 0,5 à 50 cc/min et la seconde quantité prédéterminée Q1 de celui-ci ou de ceux-ci est de 1 à 100 cc/min.

# FIG.IA

# FIG.IB

# FIG.2A

8  8  8

7

6

# FIG.2B

8  9  8  9  8  9

7

6

# FIG.3A

# FIG.3B

# FIG.3C

# FIG.3D

# FIG.4A

# FIG.4B

# FIG.4C

EP 0 298 155 B1

# FIG.5

$I$ : $WF_6(g) + \frac{3}{2} Si(s) \longrightarrow W(s) + \frac{3}{2} SiF_4(g)$

$II$ : $WF_6(g) + 3H_2(g) \longrightarrow W(s) + 6HF(g)$

$III$ : $WF_6(g) + \frac{3}{2} SiH_4(g) \longrightarrow W(s) + \frac{3}{2} SiF_4(g) + 3H_2(g)$